# EUROPEAN PATENT APPLICATION

(11) **EP 0 636 888 A2**
(43) Date of publication of application: **01.02.1995**
(21) Application number: 94304773.8
(22) Date of filing: 30.06.1994
(51) Int. Cl.: G01R 13/28, G01R 13/34

(54) **Four channel split-lissajous display**

(30) Priority: 26.07.1993 US 96394
(71) Applicant: TEKTRONIX, INC., Wilsonville, Oregon 97070-1000 (US)
(72) Inventor: Thompson, William, Beaverton, Oregon 97005 (US)
(74) Representative: Molyneaux, Martyn William

(57) **Abstract**

A split-lissajous display presents two pairs of input signals simultaneously. The signal pairs are used to calculate respective lissajous figures, and then one-half of one lissajous figure is stored in a display memory (25) with a first contrast, such as light on a dark background, and one-half of the other lissajous figure is stored in the display memory with a second contrast, such as dark on a light background. The contents of the display memory are scanned for display in a raster scan format to present the split-lissajous display.

## Description

### Background of the Invention

The present invention relates to multiple signal displays, and more particularly to a four channel split-lissajous display that presents two lissajous figures on a single display.

Lissajous figures are created on an instrument display by connecting one of a pair of signals to an x-axis input and the other of the pair to a y-axis input. Many audio monitor products display the phase relationship of two audio signals, such as the left channel and right channels of a stereo pair, with a lissajous figure. By observing the lissajous figure certain frequency, amplitude and phase characteristics of the signal pair may be determined. However this type of display does not lend itself to more than a single pair of input signals.

With serial digital audio signals, such as AES/EBU audio, two input serial digital signals represent four audio signals. Using a conventional lissajous figure display requires some means for differentiating the two pairs of signals, and is likely to result in a confusing display. Color may be used to differentiate the two lissajous figures, but for a monochrome display providing two lissajous figures on the same display in an apparent simultaneous display presents a confusing display for an operator.

What is desired is a method of simultaneously displaying two lissajous figures in a clear and unambiguous manner.

### Summary of the Invention

Accordingly the present invention provides a four channel split-lissajous display by splitting a display screen and displaying one-half of a lissajous figure for one pair of signals in one-half of the screen and one-half of a lissajous figure for another pair of signals in the other one-half of the screen. Two pairs of signals are provided at respective inputs to an instrument and each pair is input selectively to the x-axis and y-axis inputs of a display device. For one-half of the screen the inputs to the x-axis and y-axis are for one pair of the signals, and for the other half the inputs are for the other pair of signals. One half of the screen is displayed in normal video and the other half is displayed in reverse video. Alternatively each half may be displayed with different grey scale backgrounds, or in different colors where a color display is used. Also each half is provided with an appropriate label to indicate the pair of signals being displayed.

The objects, advantages and other novel features of the present invention are apparent from the following detailed description when read in conjunction with the appended claims and attached drawing.

### Brief Description of the Drawing

Fig. 1 is a block diagram of an instrument that presents a four channel split-lissajous display according to the present invention.

Fig. 2 is a plan view of the four channel split-lissajous display according to the present invention.

### Description of the Preferred Embodiment

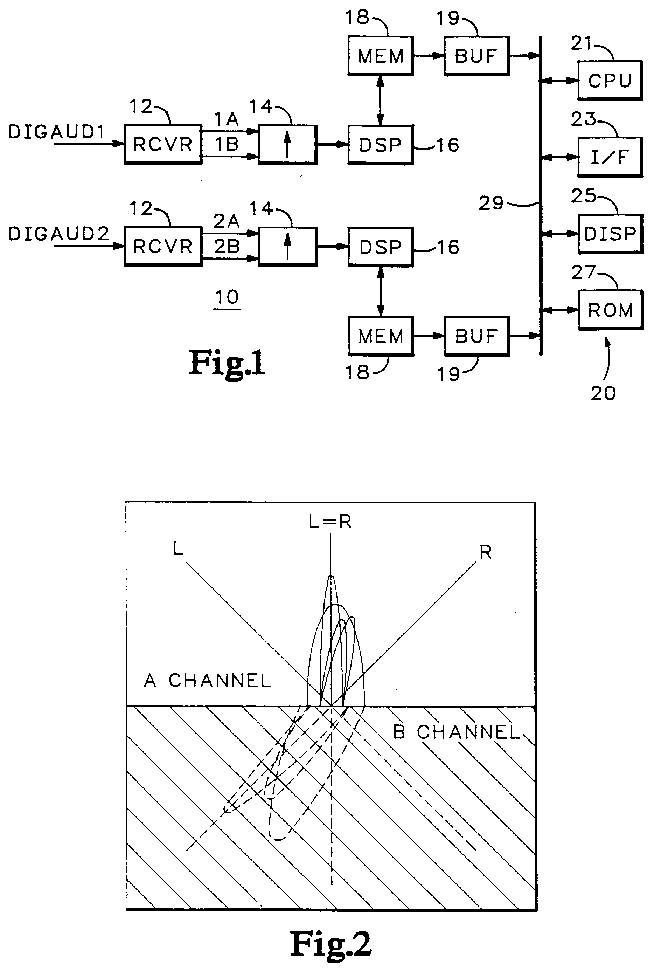

Referring now to Fig. 1 a graphical display system **10** is shown. Two serial digital signals **DIG_AUD1**, **DIG_AUD2**, each containing two digital audio signals such as two AES/EBU serial digital audio signals, are input to respective receivers **12**. The receivers **12** each extract the digital samples and form them into two channels **A**, **B** of digital data. The two channels of digital data from each input signal are input to an oversampler **14** and then to a digital signal processor (DSP) **16**. Each DSP **16** converts the two channels of digital data into a lissajous figure which represents certain characteristics between the two channels. The lissajous figure is represented by coordinate points in orthogonal coordinates, i.e., as x and y coordinates. The coordinate points access respective memories **18** to provide a display map, with each coordinate point of the lissajous figure in the memory having a first value and all other coordinate points, i.e., the background, having a second value. The contents of the memories **18** are transferred via buffers **19** to a microprocessor **20**. The microprocessor **20** includes a computer processing unit (CPU) **21**, an interface circuit (I/F) **23**, a raster scan display system with associated memory **25**, a programmable read only memory (PROM) **27** and a microprocessor bus **29**. The buffers **19** provide the contents of the memories **18** to the bus **29**, and the CPU **21**, I/F **23**, display system **25** and PROM **27** also are coupled to the bus **29**.

To present the split-lissajous display, since the lissajous figures are symmetrical about a central axis, the first half of the memory **18** of one input channel is transferred to one-half of the memory of the display system **25** and the second half of the memory of the other input channel is transferred to the other half of the display system memory. Either in transferring the lissajous figures from the channel memories **18**, or in initially loading the channel memories, the contents of one half of the display system memory have two values representing the lissajous figure and background for one input channel while the contents of the other half of the display system memory have two values different from the first half representing the lissajous figure and background for the other input channel. If the display system **25** is in monochrome, the lissajous figure for one half of the display may be light on a dark background while the lissajous for the other half may be reversed, i.e., dark on a light background. Alternatively four different colors may be used. A split-lissajous display is shown in Fig. 2.

Although the split-lissajous display is described above with reference to a digital signal system, the split-lissajous display may also be used in an analog system having four separate signal inputs. The two pairs of input signals are input to a pair of switches, the output of one switch being coupled to the x-axis input of a display screen and the output of the other switch being coupled to the y-axis input of the display screen. When the y-input for one pair of signals is positive, the switches pass that pair of signals to the inputs of the display screen. When the y-input for the other pair is negative, the switches pass that pair of signals to the inputs of the display screen. Alternatively the switches are alternated between the two pairs of input signals on a repetitive basis, with one pair of signals being clipped for y-values less than zero and the other pair of signals being clipped for y-values greater than zero. Also the z-axis drive voltage may be inverted according to the position of the switches so that the one pair of signals is displayed as a reverse contrast to the other pair of signals.

Another alternative is to sense the position of the raster scan on the display. If the raster scan is in the upper half of the display, then the output of one pair is used. If the raster scan is in the lower half of the display, then the output of the other pair is used. Further the input signals may be digitized and treated as digital sources.

Thus the present invention provides a four channel split-lissajous display that clearly and unambiguously shows the relationships between two pairs of input signals by displaying one lissajous figure in one-half of the display and another lissajous figure in the other one-half of the display with a different contrast.

## Claims

1. A method of displaying four signals in a split-lissajous display comprising the steps of:
creating two lissajous figures from the four signals, each lissajous figure representing the relationship between a unique pair of the four signals; and
displaying one-half of one lissajous figure in one-half of a display screen and one-half of the other lissajous figure in the other one-half of the display screen to provide the split-lissajous display.

2. The method as recited in claim 1 wherein the displaying step comprises the steps of:
storing the one-half of the one lissajous figure in a display memory (25) having a first contrast;
storing the one-half of the other lissajous figure in the display memory having a second contrast distinctive from the first contrast; and
displaying the contents of the display memory as the split-lissajous display.

3. The method as recited in claim 2 wherein the first contrast presents the one lissajous figure as light against a dark background and the other lissajous figure as dark against a light background.

4. The method as recited in claim 2 wherein the first contrast presents the one lissajous figure as a first color against a background of a second color and the other lissajous figure as a third color against a background of a fourth color.

5. The method as recited in claim 2 wherein each storing step comprises the steps of:
initializing the contents of the display memory to be of an initial shade; and
storing the lissajous figure into the display memory as a contrasting shade.
